Europäisches Patentamt

European Patent Office

Office européen des brevets

(11) Numéro de publication: **0 387 948 B1**

# FASCICULE DE BREVET EUROPEEN

(45) Date de publication de fascicule du brevet: **10.08.94**  (51) Int. Cl.5: **H03F 1/32**, H04L 27/34

(21) Numéro de dépôt: **90200548.7**

(22) Date de dépôt: **08.03.90**

(54) **Circuit de prédistorsion adaptative à mémoire.**

(30) Priorité: **14.03.89 FR 8903306**

(43) Date de publication de la demande:
**19.09.90 Bulletin 90/38**

(45) Mention de la délivrance du brevet:
**10.08.94 Bulletin 94/32**

(84) Etats contractants désignés:
**DE FR GB IT SE**

(56) Documents cités:
**DE-C- 3 221 911**
**GB-A- 2 173 074**

**IEEE GLOBAL TELECOMMUNICATIONS
CONFERENCE & EXHIBITION,Hollywood, Florida, 28 nov. - 1 dec. 1988, vol.1, pages
8.4.1-8.4.5, IEEE,New York us P.VANDAMME
et al. :"Performance of adaptive data predistortion applied to 22N-OAM radio systems"**

(73) Titulaire: **LABORATOIRES D'ELECTRONIOUE
PHILIPS
3, Avenue Descartes
F-94450 Limeil-Brévannes (FR)**
(84) Etats contractants désignés:
**FR**

(73) Titulaire: **N.V. Philips' Gloeilampenfabrieken
Groenewoudseweg 1
NL-5621 BA Eindhoven (NL)**
(84) Etats contractants désignés:
**DE GB IT SE**

(72) Inventeur: **Karam, Georges, Société Civile
S.P.I.D.
209 rue de l'Université
F-75007 Paris (FR)**
Inventeur: **Sari, Hikmet, Société Civile S.P.I.D.
209 rue de l'Université
F-75007 Paris (FR)**

(74) Mandataire: **Landousy, Christian et al
Société Civile S.P.I.D.
156, Boulevard Haussmann
F-75008 Paris (FR)**

## Description

L'invention concerne un circuit de prédistorsion adaptative à mémoire pour système de transmission numérique qui transmet des données d'entrée, propres à des niveaux d'une constellation C, émises à la cadence d'une horloge symbole de période T à l'aide d'un modulateur et d'un amplificateur de puissance qui distord le signal en créant des taches dans la constellation, le circuit comprenant :

. un dispositif de prédistorsion qui prédistord en sens opposé les données d'entrée en phase et en quadrature $a_n = (a'_n, a''_n)$ avant leur passage dans l'amplificateur afin de transmettre des niveaux attendus, le dispositif de prédistorsion tenant compte simultanément de L symboles reçus $a_{n+(L-1)/2} \ldots a_n \ldots a_{n-(L-1)/2}$ qui sont pour cela temporairement stockés dans une batterie de registres à décalage d'entrée,

. un circuit d'adaptation qui à partir d'une démodulation du flux de données transmises adapte continûment le dispositif de prédistorsion au flux des données d'entrée, à l'aide d'un circuit de comparaison qui compare les données d'entrée en phase et en quadrature $(a'_n, a''_n)$ et les données démodulées en phase et en quadrature $(y'_n, y''_n)$, et à l'aide d'un circuit d'interface, qui met en oeuvre un algorithme d'adaptation.

L'invention trouve ses applications dans les systèmes de transmission numérique tels que les modems de transmission de données, les faisceaux hertziens, les systèmes de communications spatiales.

Pour une utilisation efficace du spectre disponible, les systèmes de transmission numérique actuels, notamment les faisceaux hertziens et les systèmes de transmission de données sur le canal téléphonique, utilisent des modulations à grands nombres d'états de phase et d'amplitude. Or ces modulations sont très sensibles à toute sorte de distorsion, et bien entendu, aux distorsions non linéaires provenant des amplificateurs, des mélangeurs et d'autres circuits non-linéaires de la chaîne de transmission. Un point particulièrement critique en faisceaux hertziens et en transmission par satellite est la non-linéarité de l'amplificateur de puissance d'émission ou de l'amplificateur de puissance embarqué dans le cas des transmissions par satellite. Ces amplificateurs sont connus pour leurs caractéristiques non-linéaires. Si on les utilise dans leur zone linéaire on ne bénéficie pas totalement de leur puissance. Si on les fait fonctionner proche de leur puissance de saturation, ils distordent le signal d'une façon inacceptable. En pratique, étant donné un amplificateur de puissance, on fixe le niveau du signal émis de façon à établir un compromis entre le rapport signal à bruit et la distorsion non-linéaire subie par le signal. Ainsi le point de fonctionnement optimal de l'amplificateur est celui minimisant les effets conjoints du bruit additif du canal et de la distorsion non-linéaire de l'amplificateur. Pour des modulations à grand nombre d'états (MAQ64 et MAQ256 par exemple), ce point est loin de la puissance de saturation de l'amplificateur, ce qui signifie que celui-ci n'est pas utilisé d'une façon efficace. Pour augmenter son efficacité, on utilise couramment des techniques de prédistorsion (fixe ou adaptative) qui permettent de réduire l'effet de la non-linéarité de l'amplificateur de puissance sur le signal émis.

Le document GB-A-2 173 074 divulgue un tel circuit.

Une technique de prédistorsion couramment utilisée consiste à placer à l'étage de fréquence intermédiaire de l'émetteur un circuit non-linéaire approchant la fonction inverse de l'amplificateur de puissance dont on vise à compenser les non-linéarités. Si l'on savait synthétiser l'inverse exact de la fonction de l'amplificateur, cette technique permettrait d'avoir un signal parfait en sortie (sans aucune distorsion non-linéaire). Toutefois, ceci n'est pas réalisable, car l'inverse exact nécessiterait un circuit de complexité infinie. En pratique, on se contente de faire une approximation et le plus souvent on limite à l'ordre 3 la série de Taylor représentant la fonction non-linéaire de l'amplificateur et on synthétise un circuit de prédistorsion, également d'ordre 3, tel que les deux circuits cascadés n'aient plus de distorsion d'ordre 3. Des termes d'ordres supérieurs (ordre 5 et ordre 7) apparaissent en sortie mais de faible amplitude comparés à la distorsion d'ordre 3 initiale. Il en résulte ainsi une certaine amélioration des performances du système. Un inconvénient de ces circuits de prédistorsion à l'étage de fréquence intermédiaire réside dans le fait que ce sont des circuits analogiques. Ils sont difficiles à rendre adaptatifs et nécessitent de temps à autre une intervention pour les réajuster et compenser les variations de la réponse de l'amplificateur avec le temps et avec la température. Cette technique de prédistorsion est en outre à exclure si l'on veut faire une commande automatique de puissance d'émission.

Une autre technique de prédistorsion, plus récente, consiste à modifier l'alphabet des données à émettre. Cette technique appelée "prédistorsion de données" ou "prédistorsion en bande de base" est connue du document brevet US 4 291 277 et de l'article de A.A.M. SALEH et J. SALZ "Adaptive linearization of power amplifiers in digital radio systems" Bell System Technical Journal Vol. 62 Avril 1983, pages 1019-1033.

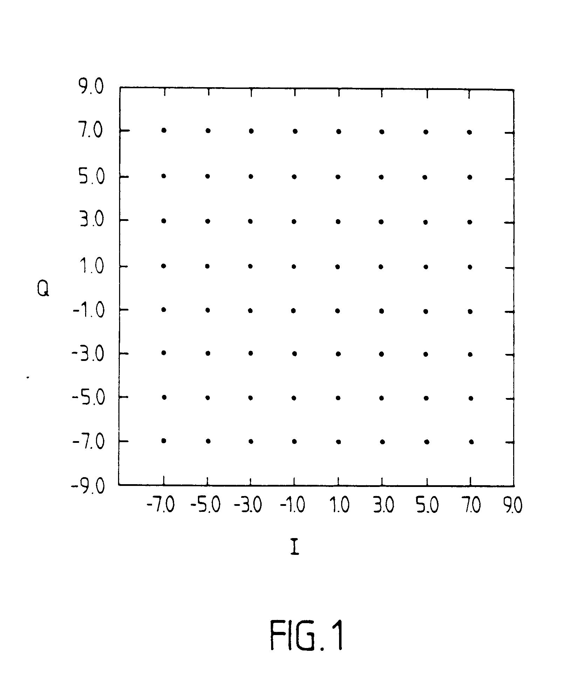

Dans l'article de A.A.M. SALEH et J. SALZ, la figure 1 est un schéma d'un circuit de prédistorsion adaptative qui fournit à l'entrée du modulateur une constellation distordue à partir de la constellation carrée d'origine, par exemple d'une modulation d'amplitude de deux porteuses en quadrature MAQ. L'amplificateur agit sur la constellation en produisant une nette compression et une nette rotation des points de grande amplitude. Pour compenser cet effet, la constellation d'origine est distordue de sorte qu'elle reprend sa forme carrée originelle après son passage dans l'amplificateur de puissance. Ainsi, lorsque le circuit de distorsion est optimisé, il forme l'inverse de l'amplificateur de puissance (à un gain et à une phase près) et permet de compenser parfaitement les non-linéarités de l'amplificateur. Pour rendre ce circuit adaptatif, le signal est repris à la sortie de l'amplificateur, démodulé, puis échantillonné à la cadence d'émission des symboles 1/T et on compare ces échantillons au point correspondant de la constellation MAQ utilisée. Ces comparaisons permettent d'obtenir un signal de commande permettant d'optimiser le circuit de prédistorsion à l'aide d'un algorithme classique. Toutefois, le schéma utilisé sur cette figure 1 est très simpliste, car il ne dispose d'aucun filtrage avant le modulateur, ni avant l'amplificateur de puissance. Il ne correspond donc pas à la solution généralement utilisée. En effet dans les systèmes réels, on utilise toujours un filtrage de mise en forme spectrale de type Nyquist permettant de limiter la bande du signal tout en garantissant une interférence intersymbole nulle aux instants de décision. Ce filtrage est en général partagé équitablement entre l'émission et la réception pour maximiser le rapport signal à bruit également aux instants de décision. Dans de tels systèmes, l'effet de la non-linéarité de l'amplificateur est double : la constellation est non seulement déformée mais il apparaît une interférence intersymbole qui associe à chaque point de la constellation un nuage de points. Or, la technique de prédistorsion décrite ci-dessus ne permet pas de compenser ce deuxième effet.

Le document brevet US 4 291 277 décrit également une technique de prédistorsion adaptative. Les buts poursuivis sont analogues. Pour opérer la correction il utilise le symbole $a_n$ reçu à un instant donné. Il indique également qu'il est possible d'associer d'autres symboles reçus à des instants différents en les stockant dans un registre d'entrée. Néanmoins cette approche est beaucoup plus complexe à traiter expérimentalement et le document brevet US 4 291 277 se borne à traiter le cas d'un seul symbole, sans traiter cette difficulté. En effet lorsque l'on prend en compte plusieurs symboles reçus à des instants différents (antérieurs et/ou postérieurs) de l'instant pour lequel le symbole $a_n$ estreçu, il est nécessaire de prendre en compte une grande quantité de données ce qui modifie le traitement à effectuer. De plus dans ce circuit le dispositif de prédistorsion est adapté d'une façon stochastique c'est-à-dire que le signal d'erreur sert directement à corriger les symboles prédistordus. Ceci est insuffisant dans le cas où un filtrage précède l'amplificateur car les points de la constellation reçue sont dans ce cas des nuages de points. Enfin il faut indiquer que le filtrage apparaissant avant le modulateur dans le document brevet US 4 291 277 n'est pas un filtrage de mise en forme d'émission mais uniquement un filtrage destiné à éliminer les fréquences élevées dues à la conversion numérique-analogique et ne permet pas de limiter la bande de signal émis à une valeur inférieure à 1/T.

Un but de l'invention consiste à définir une structure d'un circuit de prédistorsion adaptative qui puisse prendre en compte et exploiter plusieurs symboles reçus à des instants différents afin de réduire la distorsion et de diminuer en sortie la taille du nuage de points obtenu.

Selon l'invention, ce but est atteint au moyen d'un circuit de prédistorsion adaptative à mémoire tel que décrit dans le préambule caractérisé en ce que le circuit d'adaptation comprend, interposé entre le circuit de comparaison et le dispositif de prédistorsion, une batterie de compteurs/accumulateurs qui détermine le centre de gravité de chaque tache de la constellation reçue en calculant un ensemble d'erreurs moyennes qui est utilisé pour adapter le dispositif de prédistorsion, le circuit de prédistorsion adaptative à mémoire comprenant en outre un premier filtre d'émission $F_e$ disposé avant le modulateur opérant sur les voies en phase et en quadrature et un second filtre $F_r$ disposé après le démodulateur opérant également sur les voies en phase et en quadrature et tel que le produit du filtrage $F_e$ par le filtrage $F_r$ corresponde à un filtrage de Nyquist.

Un but secondaire de l'invention consiste à réduire le plus possible la quantité de composants nécessaires pour réaliser un tel circuit en particulier la taille des mémoires.

Pour cela, une simplification consiste à effectuer un traitement sur la base d'un quart de constellation et à en déduire les résultats pour l'ensemble de la constellation.

Ce but secondaire est atteint en ce que, dans le circuit de prédistorsion adaptative à mémoire selon l'invention, entre la batterie de registres d'entrée et le dispositif de prédistorsion est interposé un dispositif de transformation de C en C/4 de la constellation C en un quart de constellation C/4 qui transforme l'ensemble des symboles reçus $a_n$ appartenant à la constellation C en leurs images $\tilde{a}_n$ appartenant à un quart de plan C/4 et opère une rotation de $k\pi/2$ sur les symboles antérieurs et postérieurs au symbole $a_n$ où k vaut 0, 1, 2 ou 3 selon le quart de plan d'origine, le dispositif de prédistorsion étant suivi d'un élément de transformation inverse de C/4 en C qui rétablit l'ordre de la constellation C, un élément de transformation de C en C/4 étant également connecté entre le circuit d'adaptation et le démodulateur dans la boucle d'adaptation. Des circuits de rotation sont nécessaires pour tourner les données postérieures et antérieures dans le même sens que celui imposé par la transformation de C en C/4 opérée sur les données $a_n$.

Une autre simplification va consister à ne prendre qu'un nombre réduit de symboles. Préférentiellement le nombre de symboles pris en compte est égal à 3 :

$a_{n-1}, a_n, a_{n+1}$.

Une autre simplification va consister à prendre qu'une partie K′ (K′<K) seulement des bits constituant les données numériques antérieures et postérieures prises en compte et ceci à l'aide d'un codeur K′/K qui fait une partition de la constellation.

Pour cela le dispositif de transformation de C en C/4 est muni, en sortie de l'élément de rotation, d'un codeur K′/K qui code en K′ bits les K bits de chaque symbole.

Une partition facile à opérer consiste à opérer une sélection des K′ bits de poids le plus fort de chaque donnée (considérée comme élément complexe).

La partie K′ peut être formée de 4 bits, les bits pris en compte étant les 2 bits de signe et les 2 bits de poids fort.

La partie K′ peut être formée de 2 bits, les bits pris en compte étant les 2 bits de signe.

L'invention sera mieux comprise à l'aide des figures suivantes données à titre d'exemple non limitatif et qui représentent :

figure 1 : la constellation d'une modulation MAQ64.

figures 2A : une constellation MAQ64 distordue par l'amplificateur de puissance dans un système sans filtrage ou dans le cas où tout le filtrage est effectué après l'étage de l'amplificateur.

figure 2B : une constellation prédistordue optimisée pour compenser la distorsion illustrée sur la figure 2A selon l'art antérieur.

figure 3A : la constellation distordue par l'amplificateur telle qu'elle apparaît lorsque le filtrage global est équitablement partagé entre l'émission et la réception et la partie à l'émission est placée avant l'amplificateur.

figure 3B : la constellation distordue avec la même situation que celle de la figure 3A, mais en incorporant le circuit de prédistorsion de l'art antérieur.

figure 4 : un schéma d'un circuit de prédistorsion adaptative à mémoire selon l'invention permettant de traiter plusieurs symboles reçus à des instants postérieurs et/ou antérieurs.

figure 5 : un schéma selon le circuit de la figure 4 avec en plus des moyens pour opérer dans un quart de plan de la constellation.

figure 6 : une représentation du mécanisme de rotation des symboles dans le plan de la constellation.

figure 7A : un schéma d'un élément de rotation.

figure 7B : un schéma d'un élément de transformation de C en C/4.

figure 7C : un schéma d'un élément de transformation de C/4 en C.

figure 8 : un schéma d'un dispositif de transformation de C en C/4 muni d'un codeur K′/K sélectionnant le nombre de bits.

figure 9 : une représentation de deux exemples de partition de la constellation MAQ64.

La figure 1 est un rappel de la représentation de la constellation d'un signal de type MAQ64. Les entrées I (en phase) et Q (en quadrature) du modulateur sont indépendantes et les symboles sur chaque voie prennent leurs valeurs dans un alphabet (±d, ±3d, ±5d, ±7d), où 2d est la distance minimale entre deux points adjacents de la constellation.

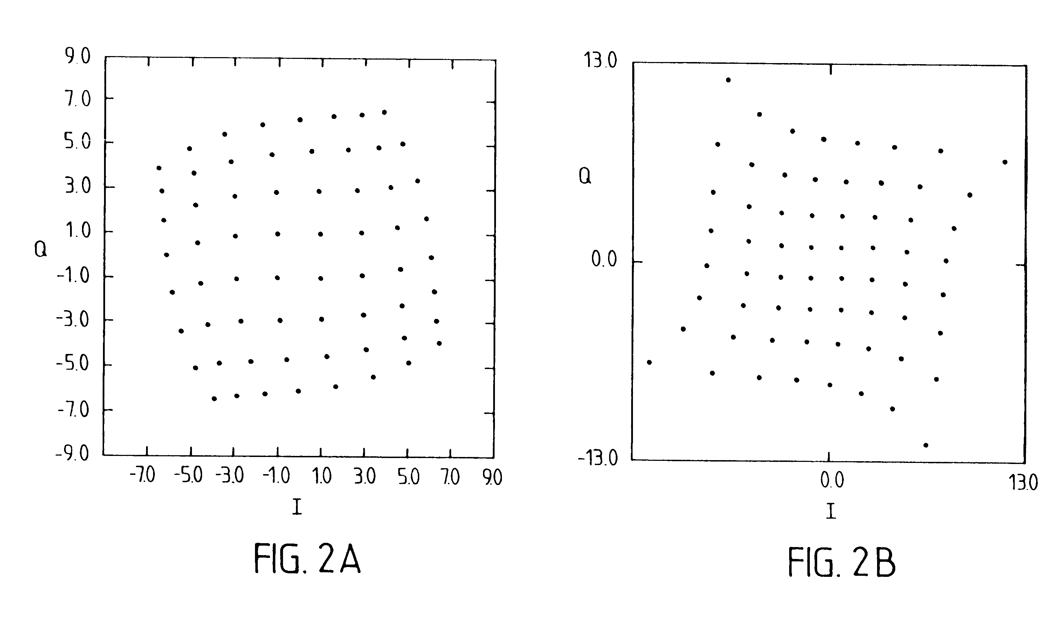

Pour être transmis le signal issu du modulateur est introduit dans un amplificateur de puissance qui est généralement utilisé à puissance réduite, c'est-à-dire dans une partie linéaire de sa caractéristique. A forte puissance cet amplificateur est non-linéaire et distord le signal de manière inacceptable. Si l'on observe une constellation de type MAQ64 à la sortie d'un tel amplificateur opérant proche de la saturation, on observe une constellation distordue comme celle représentée sur la figure 2A. Selon l'art antérieur il suffit alors de prédistordre dans le sens opposé la constellation selon le schéma de la figure 2B pour que en sortie de l'amplificateur on obtienne la constellation d'origine non déformée. Or une situation aussi simple n'est pas conforme à la réalité où il existe toujours un filtrage avant l'amplificateur de puissance notamment pour limiter la bande du signal. En absence de filtrage, le signal à l'entrée du modulateur varie par paliers une fois par durée symbole T. Ainsi, un circuit de prédistorsion agissant sur le signal à cadence 1/T permet une compensation parfaite. Par contre, lorsque le signal est filtré, il ne varie plus par paliers mais d'une façon continue. Pour une compensation parfaite de l'effet de la non-linéarité, il ne suffit plus d'observer le signal une fois par durée symbole T et de compenser la distorsion à ces moments là.

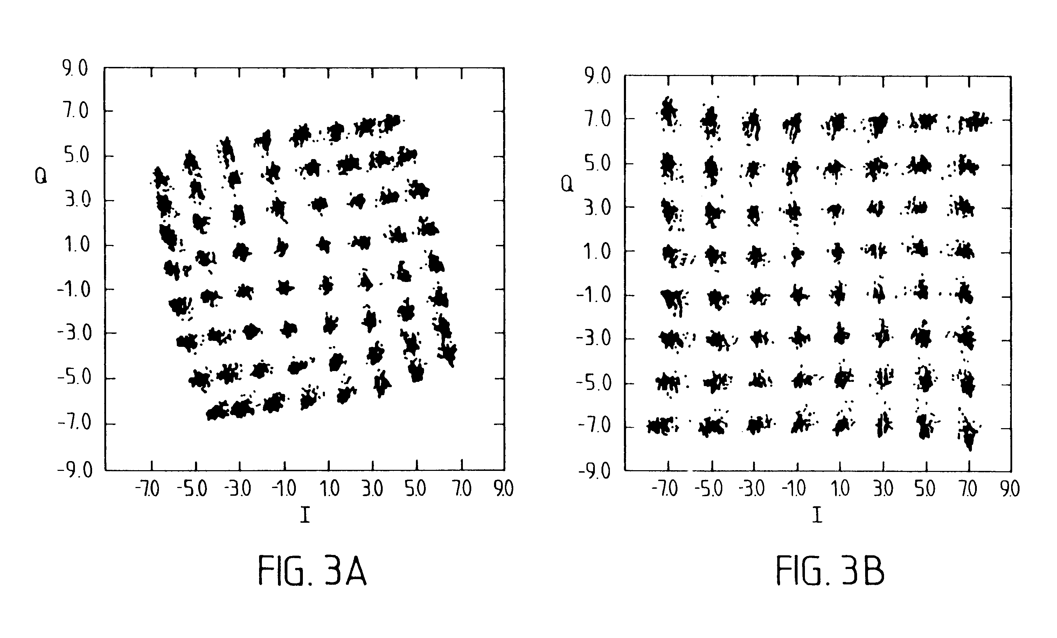

En présence d'un signal filtré la constellation à la sortie de l'amplificateur est représentée sur la figure 3A. Elle devient telle que représentée sur la figure 3B avec le circuit de prédistorsion de l'art antérieur. Ainsi chaque point de la constellation devient une tache de points ce qui est inacceptable. Pour opérer avec un signal filtré il faut donc opérer une correction plus complexe.

L'invention reconnaît que le signal $y_n$ reçu par le récepteur ne dépend pas seulement du symbole $a_n$ à l'instant nT, mais aussi des symboles du futur $a_{n+1}$, $a_{n+2}$,... et des symboles du passé $a_{n-1}$, $a_{n-2}$,... . Ceci reflète l'interférence intersymbole qui se traduit par la transformation des points de la constellation en taches. Une prédistorsion de données parfaite consiste à émettre des symboles prédistordus $b_n$ à la place des symboles d'origine $a_n$ de sorte qu'à la réception, le signal reçu $y_n$ soit égal à $a_n$. Comme $y_n$ est une fonction de ...$a_{n-1}$, $a_n$, $a_{n+1}$,... le symbole prédistordu $b_n$ doit aussi être une fonction de $(a_n,\sigma_n)$ avec $\sigma_n = (...a_{n-2}$, $a_{n-1}$, $a_{n+1}$, $a_{n+2}$,...). Donc le dispositif de prédistorsion doit être adressé par tous les symboles $(a_n,\sigma_n)$ à la fois pour délivrer en sortie le symbole prédistordu $b_n$. Cette technique est appelée prédistorsion à mémoire. Pour avoir un dispositif de prédistorsion réalisable, on l'adresse par un nombre fini de symboles. Par exemple avec $L = 2M + 1$ symboles, le dispositif de prédistorsion est alors adressé par $(a_n$, $\sigma'_n)$ où $\sigma'_n = (a_{n-M},a_{n-M+1},..,a_{n-1},a_{n+1},..,a_{n+M})$.

Soit D le nombre de points de la constellation. Adresser le dispositif de prédistorsion par $(a_n,\sigma'_n)$ revient à découper chacune des D taches de la constellation reçue en $D^{2M}$ sous-taches. Chacune de ces sous-taches correspond à une réalisation particulière de $\sigma'_n$. L'objet de la prédistorsion à mémoire $L = 2M + 1$ est de calculer $b_n$ fonction de $(a_n,\sigma'_n)$ tels que les centres de gravité des sous-taches $(D \times D^{2M}$ centres) soient confondus avec les points correspondants de la constellation d'origine. Ainsi après avoir fait cette prédistorsion on obtient une constellation reçue telles que les D taches résultantes soient d'une grosseur plus réduite que celle obtenue avec le cas où l'on fait une prédistorsion sans mémoire c'est-à-dire quand le dispositif de prédistorsion est seulement adressé par $a_n$.

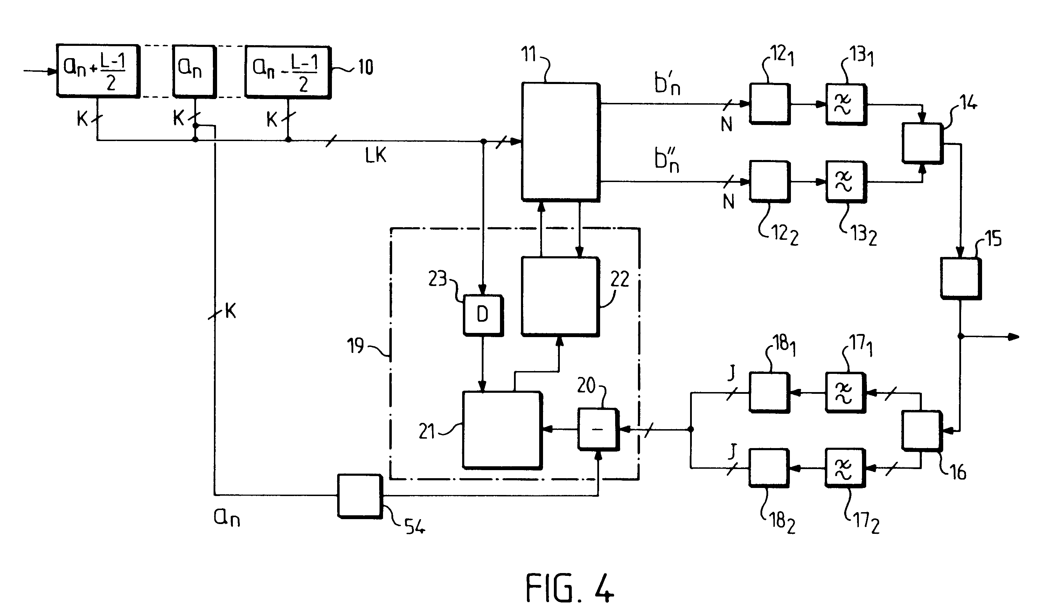

Sur le schéma de la figure 4 est représenté un circuit de prédistorsion adaptative muni d'une mémoire formée par une batterie 10 de registres à décalage d'entrée. A un instant donné cette batterie stocke L symboles $a_{n+(L-1)/2}$... $a_n$ ... $a_{n-(L-1)/2}$. Tous ces symboles sont codés sur K bits. L'ensemble des LK bits sert à adresser un dispositif de prédistorsion 11 qui préférentiellement est constitué par une mémoire RAM. Le dispositif 11 délivre les données numériques prédistordues en phase $b'_n$ et en quadrature $b''_n$ codées sur N bits. Ces données numériques sont transformées en données analogiques respectivement par des convertisseurs N/A $12_1$ et $12_2$ suivis respectivement de filtres d'émission $13_1$ et $13_2$. Ces deux flux de données servent à moduler une porteuse dans le modulateur 14 qui est suivi de l'amplificateur non-linéaire 15 lui-même relié aux organes d'émission. Une boucle d'adaptation reprend le signal de sortie de l'amplificateur 15. Cette boucle comprend un démodulateur 16 qui délivre des signaux en phase et en quadrature respectivement à deux filtres $17_1$, $17_2$ reliés respectivement à deux convertisseurs analogique/numérique $18_1$, $18_2$ qui sont connectés au circuit d'adaptation 19. Les signaux en phase et en quadrature ainsi filtrés, codés sur J bits $(y'_n,y''_n)$, sont introduits dans un circuit de comparaison 20 qui reçoit les K bits du symbole $a_n$ pour délivrer une erreur. Cette erreur entre dans une batterie de compteurs/accumulateurs 21 qui stocke cette valeur pour déterminer après un temps de moyennage les centres de gravité des sous-taches de la constellation. La comparaison entre les valeurs des centres de gravité et des points de la constellation nominale donne un ensemble d'erreurs qui est utilisé par un circuit d'interface 22 qui met en oeuvre un algorithme d'adaptation afin d'adapter les données stockées dans le dispositif de prédistorsion 11. Deux éléments de retard 23 et 54 servent à synchroniser les données.

Les filtres d'émission $13_1$, $13_2$ doivent être cascadés avec celui placé à la réception (non représenté) pour donner un filtrage global vérifiant le critère de Nyquist, c'est-à-dire annulant l'interférence intersymbole à l'instant de décision en absence de l'amplificateur non-linéaire. Par conséquent le signal à la sortie du démodulateur 16 auxiliaire doit subir un filtrage $17_1$, $17_2$ identique à celui placé à la réception avant d'être comparé au signal désiré pour évaluer le signal d'erreur qui sert à l'adaptation.

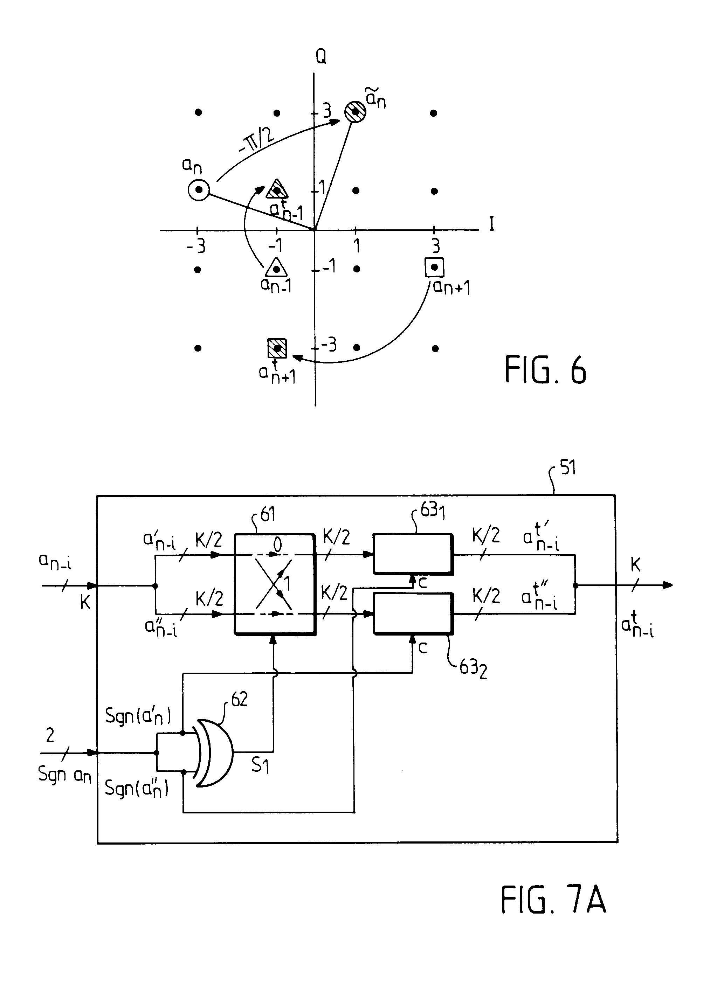

Pour simplifier le dispositif de prédistorsion 11, préférentiellement le nombre de symboles pris en compte peut être égal à 3 $(a_{n-1},a_n,a_{n+1})$. Mais dans le cas de modulations à grand nombre d'états, il est souhaitable de réduire encore le nombre de bits pris en compte pour réduire la taille du dispositif de prédistorsion. Pour cela on remarque (figure 6) que vu la symétrie de la constellation un seul quart de plan est suffisant pour représenter les symboles prédistordus. Pour obtenir $\tilde{a}_n$ l'image d'un symbole quelconque $a_n$ de la constellation dans le premier quart de plan, il suffit de lui faire subir une rotation de $k\pi/2$ où k vaut 0,1,2 ou 3. La mémoire adressée par $\tilde{a}_n$ à la place de $a_n$, va délivrer $\tilde{b}_n$ le symbole prédistordu situé dans le premier quart de constellation; une opération de $-k\pi/2$ est nécessaire pour retrouver $b_n$ (symbole prédistordu correspondant à $a_n$). Comme $\tilde{a}_n$ est positif (partie réelle positive et partie imaginaire positive), on peut laisser tomber les deux bits de signe et réduire la taille de la mémoire par 4. En procédant ainsi les symboles du futur et du passé $a_{n+1}$ et $a_{n-1}$ doivent subir la même rotation que $a_n$ a subi (de même angle) pour donner

$$a_{n+1}^{t}$$

et

$$a_{n-1}^{t}$$

deux autres symboles dits symboles tournés appartenant à toute la constellation et qui serviront à adresser la mémoire avec $\tilde{a}_n$. Le schéma de la figure 6 montre un exemple de passage du triplet $(a_{n-1}, a_n, a_{n+1})$ à

$$(a_{n-1}^{t}, \; \tilde{a}_n, \; a_{n+1}^{t})$$

dans le cas d'une constellation MAQ 16.

Un circuit de transformation constellation/quart de constellation est donc nécessaire pour donner $\tilde{a}_n$ en sortie en fonction de $a_n$. Un autre circuit de transformation inverse est nécessaire. Enfin un circuit de rotation est nécessaire pour donner

$$(a_{n-1}^{t}, a_{n+1}^{t})$$

en fonction de $(a_{n-1}, a_{n+1})$. Avec cette simplification qui nécessite de très simples circuits supplémentaires une prédistorsion à mémoire avec $L = 3$ implique des mémoires de capacité 1 K mots en MAQ 16, et 64 K mots en MAQ 64.

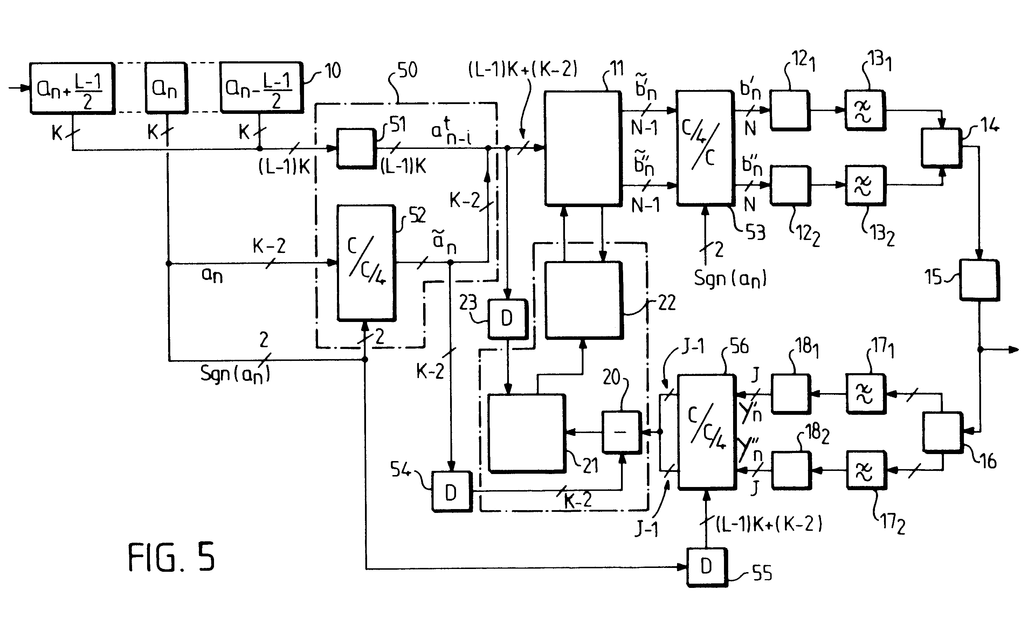

Un circuit de prédistorsion adaptative à mémoire qui met en oeuvre cette limitation est représenté sur la figure 5. Les mêmes éléments que ceux de la figure 4 sont représentés avec les mêmes repères. En plus, entre la batterie 10 de registres et le dispositif de prédistorsion 11 est interposé un dispositif de transformation 50 formé d'une batterie 51 d'éléments de rotation qui opère sur les $(L-1)K$ données $a_{n-i}$ (avec $i \neq 0$) antérieures et postérieures à la donnée $a_n$ et d'un élément de transformation 52 de C en C/4 qui reçoit d'une part les K-2 bits les plus faibles de la donnée $a_n$ et d'autre part ses 2 bits de signe. La batterie d'éléments de rotation 51 délivre $(L-1)K$ bits des données tournées

$$a_{n-i}^{t}$$

et l'élément de transformation 52 délivre (K-2) bits des données $\tilde{a}_n$. Le dispositif de prédistorsion 11 est adressé par les $(L-1)K + (K-2)$ bits et délivre les données prédistordues en phase $\tilde{b}'_n$ et en quadrature $\tilde{b}''_n$ dans un quart de plan de la constellation. Elles sont à leur tour transformées sur la totalité de la constellation par un élément de transformation inverse 53 qui reçoit les deux bits de signes de

$(a'_n, a''_n)$ et restitue les données $b'_n$ et $b''_n$ prédistordues. Le reste des opérations avant l'émetteur reste inchangé.

Sur la voie d'adaptation, après le démodulateur 16, les filtres $17_1$ et $17_2$ et les convertisseurs analogique-numérique $18_1$ et $18_2$, on dispose également un élément de transformation 56 de C en C/4 qui opère sur les voies en phase et en quadrature adressé par les 2 bits de signe de $(a'_n, a''_n)$. Cet élément de transformation est identique à l'élément 52. Les données délivrées sont traitées par le circuit de comparaison 20 et la batterie de compteurs/accumulateurs 21 comme préalablement. Des éléments de retard 54, 55 permettent de synchroniser les opérations.

Un exemple de réalisation d'un élément de rotation de la batterie 51 est représenté sur la figure 7A. Les bits d'une donnée $a_{n-i}$ (avec $i \neq 0$) entrent sur un permutateur 61 qui permute $a'_{n-i}$ et $a''_{n-i}$ sous la commande d'un signal $S_1$ issu d'une porte OU-exclusif 62 qui reçoit les 2 bits de signes des voies en phase $a'_n$ et en quadrature $a''_n$ relatives à la donnée $a_n$ (avec par exemple le signe positif codé par 0 et le signe négatif codé par 1). Les deux sorties du permutateur 61 entrent respectivement dans un bloc de changement de signe $63_1$, $63_2$ contrôlés respectivement par le signe de $a''_n$ (sgn $a''_n$) et le signe de $a'_n$ (sgn $a'_n$). On obtient ainsi des données tournées

$$a'^{t}_{n-i}$$

et

$$a''^{t}_{n-i}.$$

Avec un signe positif codé par 0 et un signe négatif codé par 1, le changement de signe s'effectue si le bit de commande est à 1, c'est-à-dire que le signe est négatif. On peut utiliser une convention inverse. Chaque donnée $a_{n-i}$ est ainsi transformée par un tel bloc de rotation.

Ainsi l'élément de rotation comprend :

. une porte ou-exclusif qui reçoit les deux bits de signe de $a'_n$ et $a''_n$ et délivre un signal de commande $S_1$,

. un permutateur qui reçoit sur une entrée $a'_{n-i}$ et sur l'autre entrée $a''_{n-i}$, avec $-(L-1)/2 \leq i \leq -(L-1)/2$, et qui permute ces données en sortie pour un état logique donné de $S_1$ et ne les permute pas pour l'état logique inverse, chaque sortie du permutateur étant suivie par un bloc de changement de signe commandé par le bit de signe initial de la voie inverse afin de délivrer les données tournées

$$a'^t_{n-i}$$

et

$$a''^t_{n-i}.$$

Le changement de signe s'effectue si le bit de commande est 1, c'est-à-dire le signe est négatif d'après nos conventions.

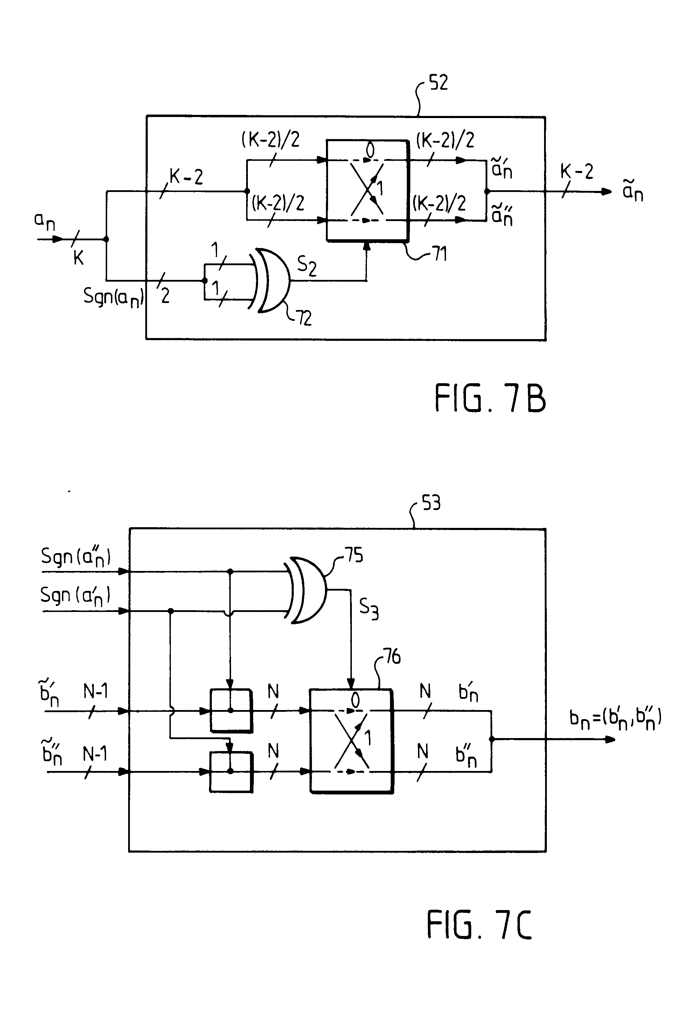

Un exemple de réalisation de l'élément de transformation 52 de C en C/4 est représenté sur la figure 7B. Les deux bits de signe de la donnée $a_n$ entrent dans une porte OU-exclusif 72 qui commande (signal $S_2$) un permutateur 71 qui permute les données en phase et en quadrature (sans leur signe) lorsque $S_2 = 1$ et ne les permute pas lorsque $S_2 = 0$. On obtient en sortie les données transformées

$$\tilde{a}_n = (\tilde{a}'_n, \tilde{a}''_n).$$

Ainsi l'élément de transformation de C en C/4 comprend une porte OU-exclusif qui reçoit les deux bits de signe de $a'_n$ et $a''_n$ et délivre un signal de commande $S_2$ qui agit sur un premier permutateur qui permute entre elles les autres bits de données $a'_n$ et $a''_n$ pour un état logique donné de $S_2$ et ne les permute pas pour l'état logique inverse afin de former les données images

$$\tilde{a}_n = (\tilde{a}'_n, \tilde{a}''_n).$$

Un exemple de réalisation de l'élément de transformation inverse 53 de C/4 en C est représenté sur la figure 7C. Les deux bits de signe de $a'_n$ et $a''_n$ entrent dans une porte OU-exclusif 75 (signal $S_3$) qui commande un permutateur 76 qui permute les données lorsque $S_3 = 1$ et ne les permute pas lorsque $S_3 = 0$. En entrée le permutateur reçoit sur une entrée les (N-1) bits de $\tilde{b}'_n$ et le bit de signe de $a''_n$ et sur l'autre entrée les (N-1) bits de $\tilde{b}''_n$ et le bit de signe de $a'_n$. On obtient en sortie les données $b'_n$ et $b''_n$ (phase et quadrature) relatives à la donnée $b_n$ prédistordue concernant la totalité de la constellation.

Ainsi l'élément de transformation de C/4 en C comprend une porte OU-exclusif qui reçoit les deux bits de signe de $(a'_n, a''_n)$ et délivre un signal de commande $S_3$ qui agit sur un permutateur qui reçoit :

.  sur une entrée, les données images $\tilde{b}'_n$ complétées par le bit de signe de $a''_n$,

.  sur l'autre entrée, les données images $\tilde{b}''_n$ complétées par le bit de signe de $a'_n$,

le permutateur permutant en sortie les données d'entrée pour un état logique donné de $S_3$ et ne les permutant pas pour l'état logique inverse afin de former les données $b_n = (b'_n, b''_n)$ prédistordues.

Une autre simplification peut être apportée au prix d'une perte de performance par rapport à la solution optimale précédente. Pour cela on ne considère que K' bits (K'<K) sur les K bits représentant les symboles du futur et du passé

$$(a^t_{n+1}, a^t_{n-1})$$

adressant la mémoire 11. On opère ainsi une partition de la constellation.

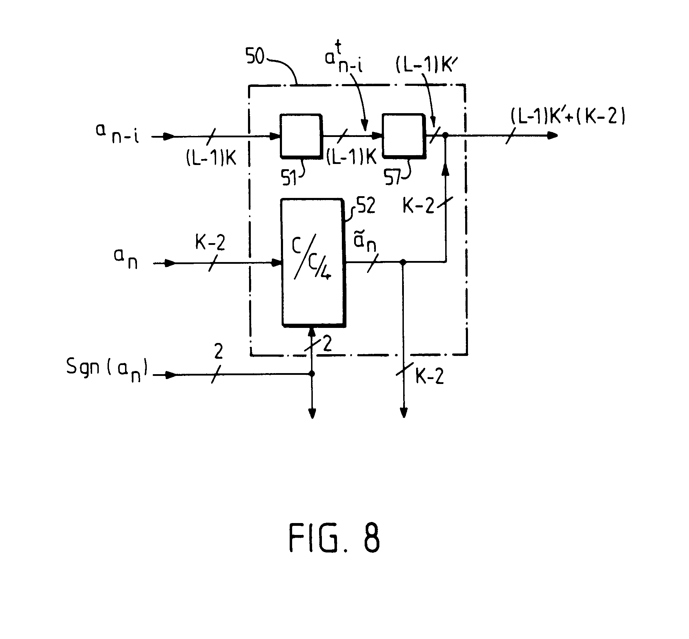

Le schéma de la figure 8 représente un dispositif de transformation 50 de C en C/4 qui comprend, en sortie de l'élément de rotation 51, un codeur K'/K 57 qui code en K' bits (K'<K) les K bits de chaque donnée délivrée.

La sortie du codeur K'/K 57 délivre les données tronquées de

$$a^t_{n-i}$$

qui groupées avec les données $\tilde{a}_n$ de l'élément 52 constituent l'adressage du dispositif de prédistorsion 11.

Un codage simple est une partition rectangulaire. Ainsi, on peut prendre par exemple en compte les deux bits de poids fort et les deux bits de signe soit K' = 4. En MAQ 16 ce niveau correspond au cas de non simplification. En MAQ 64 et MAQ 256 on obtient des mémoires de 4 K mots et de 16 K mots respectivement si la mémoire de prédistorsion considérée est de taille L = 3. Cette technique de prédistorsion avec mémoire L = 3 utilisant des mémoires de 4 K en MAQ 64 et 16 K en MAQ 256 donne des gains proches de 2 dB par rapport à la prédistorsion de données sans mémoire conventionnelle.

Une simplification plus poussée, toujours avec une partition rectangulaire, consiste à ne considérer que les bits de signes soit K' = 2. Dans ce cas on obtient pour une prédistorsion avec mémoire L = 3 des mémoires de 64 mots en MAQ 16, 256 mots en MAQ 64 et 1 K mot en MAQ 256. Le gain dans ce cas se trouve assez réduit en MAQ64 et MAQ256 mais intéressant en MAQ16.

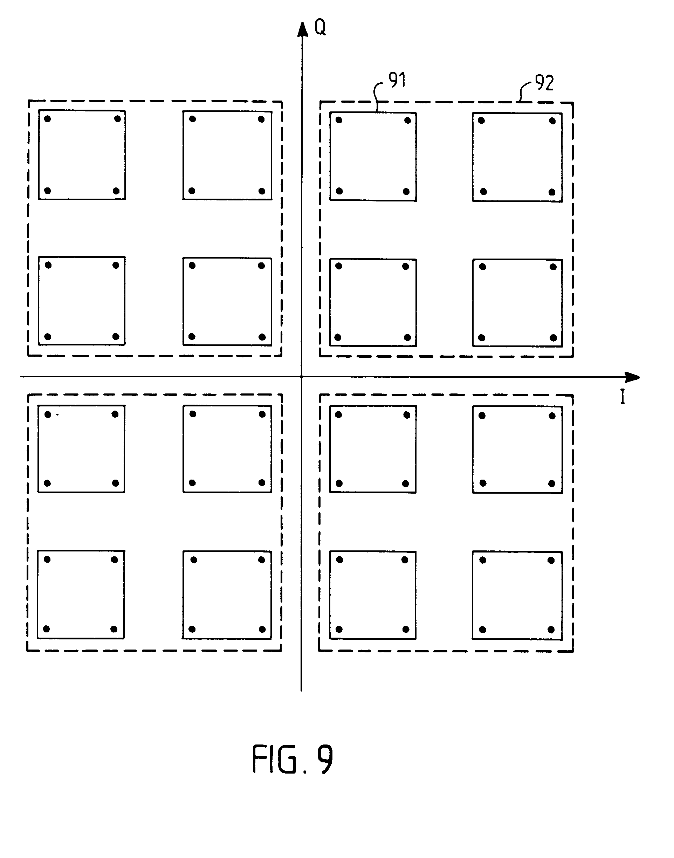

La figure 9 représente ces deux exemples de partition K' = 4 et K' = 2 dans le cas d'une modulation MAQ64.

La partition avec K' = 4 est représentée par l'ensemble des carrés, tels que le groupement 91, qui regroupe 4 états adjacents de la constellation.

La partition avec K' = 2 est représentée par les quatre carrés, tels que le groupement 92, qui regroupe 16 états d'un même quart de plan.

D'autres partitions peuvent être envisagées qui sont sélectionnées par le codeur K'/K.

## Revendications

1. Circuit de prédistorsion adaptative à mémoire pour système de transmission numérique qui transmet des données d'entrée, propres à des niveaux d'une constellation C, émises à la cadence d'une horloge symbole de période T à l'aide d'un modulateur (14) et d'un amplificateur de puissance (15) qui distord le signal en créant des taches dans la constellation, le circuit comprenant :
   - un dispositif de prédistorsion (11) qui prédistord en sens opposé les données d'entrée en phase et en quadrature $a_n = -(a'_n, a''_n)$ avant leur passage dans l'amplificateur afin de transmettre des niveaux attendus, le dispositif de prédistorsion tenant compte simultanément de L symboles reçus $a_{n+(L-1)/2}... a_n ... a_{n-(L-1)/2}$ qui sont pour cela temporairement stockés dans une batterie (10) de registres à décalage d'entrée,
   - un circuit d'adaptation (19) qui à partir d'une démodulation (16) du flux de données transmises adapte continûment le dispositif de prédistorsion (11) au flux des données d'entrée, à l'aide d'un circuit de comparaison (20) qui compare les données d'entrée en phase et en quadrature $(a'_n, a''_n)$ et les données démodulées en phase et en quadrature $(y'_n, y''_n)$ et à l'aide d'un circuit d'interface (22) qui met en oeuvre un algorithme d'adaptation caractérisé en ce que le circuit d'adaptation (19) comprend, interposé entre le circuit de comparaison (20) et le dispositif de prédistorsion (11), une batterie (21) de compteurs/accumulateurs qui détermine le centre de gravité de chaque tache de la constellation reçue en calculant un ensemble d'erreurs moyennes qui est utilisé pour adapter le dispositif de prédistorsion (11), le circuit de prédistorsion adaptative à mémoire comprenant en outre un premier filtre d'émission $F_e$ ($13_1, 13_2$) disposé avant le modulateur (14) opérant sur les voies en phase et en quadrature et un second filtre $F_r$ ($17_1, 17_2$) disposé après le démodulateur (16) opérant également sur les voies en phase et en quadrature et tel que le produit du filtrage $F_e$ par le filtrage

$F_r$ corresponde à un filtrage de Nyquist.

2. Circuit de prédistorsion adaptative à mémoire selon la revendication 1 caractérisé en ce qu'entre la batterie (10) de registres d'entrée et le dispositif de prédistorsion (11) est interposé un dispositif (50) de transformation de C en C/4 de la constellation C en un quart de constellation C/4 qui transforme l'ensemble des symboles reçus $a_n$ appartenant à la constellation C en leurs images $\tilde{a}_n$ appartenant à un quart de plan C/4 et opère une rotation de $k\pi/2$ sur les symboles antérieurs et postérieurs au symbole $a_n$ où k vaut 0, 1, 2 ou 3 selon le quart de plan d'origine, le dispositif de prédistorsion (11) étant suivi d'un élément (53) de transformation inverse de C/4 en C qui rétablit l'ordre de la constellation C, un élément (56) de transformation de C en C/4 étant également connecté entre le circuit d'adaptation (19) et le démodulateur (16) dans la boucle d'adaptation.

3. Circuit selon la revendication 2 caractérisé en ce que le dispositif (50) de transformation de C en C/4 délivre les données images $\tilde{a}_n$ et les données tournées

$$a_{n-i}^t$$

(avec i≠0) et pour cela comprend :
   - une batterie (51) d'éléments de rotation qui opère sur les données $a_{n-i}$ antérieures et postérieures aux données $a_n$,
   - un élément (52) de transformation de C en C/4 qui opère sur les données $a_n$.

4. Circuit selon la revendication 3 caractérisé en ce qu'un élément de rotation de la batterie (51) comprend :
   - une porte ou-exclusif (62) qui reçoit les deux bits de signe de $a'_n$ et $a''_n$ et délivre un signal de commande $S_1$,
   - un permutateur (61) qui reçoit sur une entrée $a'_{n-i}$ etsur l'autre entrée $a''_{n-i}$ avec $-(L-1)/2 \le i \le (L-1)/2$, et qui permute ces données en sortie pour un état logique donné de $S_1$ et ne les permute pas pour l'état logique inverse, chaque sortie du permutateur étant suivie par un bloc de changement de signe ($63_1, 63_2$) commandé par le bit de signe initial de la voie inverse afin de délivrer les données tournées

$$a'^{t}_{n-i}$$

et

$$a''^{t}_{n-i}$$

5. Circuit selon les revendications 3 ou 4 caractérisé en ce que l'élément (52) (56) de transformation de C en C/4 comprend une porte OU-exclusif (72) qui reçoit les deux bits de signe de $a'_n$ et $a''_n$ et délivre un signal de commande $S_2$ qui agit sur un premier permutateur (71) qui permute entre elles les autres bits de données $a'_n$ et $a''_n$ pour un état logique donné de $S_2$ et ne les permute pas pour l'état logique inverse afin de former les données images $\tilde{a}_n = -(\tilde{a}'_n, \tilde{a}''_n)$.

6. Circuit selon une des revendications 2 à 5 caractérisé en ce que l'élément (53) de transformation de C/4 en C comprend une porte OU-exclusif (75) qui reçoit les deux bits de signe de $(a'_n, a''_n)$ et délivre un signal de commande $S_3$ qui agit sur un permutateur (76) qui reçoit :
   . sur une entrée, les données images $\tilde{b}'_n$ complétées par le bit de signe de $a''_n$,
   . sur l'autre entrée, les données images $\tilde{b}''_n$ complétées par le bit de signe de $a'_n$,
   le permutateur (76) permutant en sortie les données d'entrée pour un état logique donné de $S_3$ et ne les permutant pas pour l'état logique inverse afin de former les données $b_n = (b'_n, b''_n)$ prédistordues.

7. Circuit selon une des revendications 1 à 6 caractérisé en ce que le nombre L de symboles pris en compte est égal à 3 : $a_{n-1}, a_n, a_{n+1}$.

8. Circuit selon une des revendications 3 à 7 caractérisé en ce que le dispositif (50) de transformation de C en C/4 est muni, en sortie de l'élément de rotation (51), d'un codeur (57) K'/K qui code en K' bits (K'<K) les K bits de chaque symbole.

9. Circuit selon la revendication 8 caractérisé en ce que les K' bits sélectionnés sont les K' bits de poids le plus fort.

10. Circuit selon la revendication 9 caractérisé en ce que K' = 4, les bits pris en compte étant les 2 bits de signe et les 2 bits de poids fort.

11. Circuit selon la revendication 9 caractérisé en ce que K' = 2, les bits pris en compte étant les 2 bits de signe.

**Claims**

1. Adaptive predistortion circuit with memory for a digital transmission system which transmits input data associated with levels of a signal constellation C and which occur at the rate of a symbol clock having a period T with the aid of a modulator (14) and a power amplifier (15) that distorts the signal by creating smeared spots (clouds) in the constellation, the circuit comprising:
   - a predistortion circuit (11) for predistorting in the reverse sense the in-phase and quadrature input data symbols $a_n = (a'_n, a''_n)$ prior to their entering the power amplifier in order to transmit expected levels, the predistortion circuit simultaneously taking into account L received input symbols $a_{n+(L-1)/2} \ldots a_n \ldots a_{n-(l-1)/2}$ which are temporarily stored in a set (10) of input shift registers, and
   - an adaptation circuit (19) for continuously adapting the predistortion circuit (11) to the stream of input data symbols in response to a demodulation (16) of the stream of transmitted data symbols, by means of a comparator circuit (20) that compares the in-phase and quadrature input data symbols $(a'_n, a''_n)$ with the in-phase and quadrature demodulated data symbols $(y'_n, y''_n)$ and by means of an interface circuit (22) that employs an adaptation algorithm, characterized in that the adaptation circuit (19) comprises, inserted between the comparator circuit (20) and the predistortion circuit (11), a set (21) of counters/accumulators which determine the centre of gravity of each smeared spot (cloud) of the received constellation by calculating a set of mean errors that is used to adapt the predistortion circuit (11), the adaptive predistortion circuit with memory further including a first transmit filter $F_e$ (13_1, 13_2) located before the modulator (14) operating on the in-phase and quadrature paths and a second filter $F_r$ (17_1, 17_2) located after the demodulator (16), also operating on the in-phase and quadrature paths and in a manner such that the product of the filtering performed by the first and second filters $F_e$ and $F_r$ corresponds with a

Nyquist filtering.

2. Adaptive predistortion circuit with memory as claimed in Claim 1, characterized in that a circuit (50) for transforming the signal constellation C into a quarter of the constellation C/4 is inserted between the set (10) of input registers and predistortion circuit (11), which C-to-C/4 transforming circuit transforms all of the received symbols $a_n$ of the constellation C into their images $\tilde{a}_n$ of a given quarter constellation plane C/4 and performs a rotation by $k\pi/2$ of the symbols preceding and subsequent to the symbol $a_n$, where $k = 0, 1, 2$ or $3$ according to the original quarter plane of the constellation C, the predistortion circuit (11) being followed by a C/4-to-C reverse transforming circuit (53) for restoring the order of constellation C, a C-to-C/4 transforming circuit (56) also being connected between the adaptation circuit (19) and the demodulator (16) in the adaptation loop.

3. Circuit as claimed in Claim 2, characterized in that the C-to-C/4 transforming circuit (50) supplies the image data $\tilde{a}_n$ and the rotated data

$$a^{t}_{n-i}$$

(with $i \neq 0$) and thereto comprises:
- a set (51) of rotation circuits which operates on the data symbols $a_{n-i}$ preceding and subsequent to the data symbol $a_n$,
- a C-to-C/4 transforming circuit (52) which transforms the data symbol $a_n$.

4. Circuit as claimed in Claim 3, characterized in that a rotation circuit of said set (51) comprises:
- an Exclusive-OR gate (62) receiving the two sign bits of $a'_n$ and $a''_n$ and supplying a control signal $S_1$,
- a permutation circuit (61) receiving data $a'_{n-i}$ at an input and data $a''_{n-i}$ at another input i with $-(L-1)/2 \leq i \leq (L-1)/2$, and permuting these data at its output for a given logic state $S_1$ and not permuting the data for the inverse logic state, each output of the permutation circuit being followed by a sign conversion block circuit $(63_1, 63_2)$ controlled by the initial sign bit of the inverse path in order to produce rotated data

$$a'^{t}_{n-i}$$

and

$$a''^{t}_{n-i}.$$

5. Circuit as claimed in Claim 3 or 4, characterized in that the C-to-C/4 transforming circuit (52) (56) comprises an Exclusive-OR gate (72) receiving the two sign bits of $a'_n$ and $a''_n$ and producing a control signal $S_2$ that controls a first permutation circuit (71) which permutes the other bits of the data $a'_n$ and $a''_n$ for a given logic state $S_2$ and which does not permute them for the inverse logic state so as to form the image data symbols $\tilde{a}_n = (\tilde{a}'_n, \tilde{a}''_n)$.

6. Circuit as claimed in one of the Claims 2 to 5, characterized in that the C/4-to-C transforming circuit (53) comprises an Exclusive-OR gate (75) receiving the two sign bits $(a'_n, a''_n)$ and supplying a control signal $S_3$ that controls a permutation circuit (76) which receives:
- at an input the image data $\tilde{b}'_n$ completed by the sign bit of $a''_n$,
- at another input the image data $\tilde{b}''_n$ completed by the sign bit of $a'_n$, the permutation circuit (76) permuting at its output the received data for a given logic state $S_3$ and not permuting said data for the inverse logic state in order to form the predistorted data symbols $b_n = (b'_n, b''_n)$.

7. Circuit as claimed in one of the Claims 1 to 6, characterized in that the number L of data symbols taken into account is equal to 3: $a_{n-1}$, $a_n$, $a_{n+1}$.

8. Circuit as claimed in one of the Claims 3 to 7, characterized in that the C-to-C/4 transforming circuit (50) comprises, at the output of the rotation circuit (51), a K-to-K' encoder (57) encoding into K' bits $(K' < K)$ the K bits of each data symbol.

9. Circuit as claimed in Claim 8, characterized in that the selected K' bits are the K' most significant bits.

10. Circuit as claimed in Claim 9, characterized in that $K' = 4$, the bits taken into account being the 2 sign bits and the 2 most significant bits.

11. Circuit as claimed in Claim 9, characterized in that $K' = 2$, the bits taken into account being the 2 sign bits.

**Patentansprüche**

1. Adaptive Vorverzerrungsschaltung mit Speicherung für ein digitales Datenübertragungssystem, die Eingangsdaten, die mit einer bestimmten Pegelkonstellation C im Takt eines Symbol-Taktgebers mit der Taktdauer T gesendet wurden, mittels eines Modulators (14) und eines Leistungsverstärkers (15), der das Signal so verzerrt, daß sich in der Konstellation Flecken bilden, überträgt und wobei diese Schaltung enthält:

   . eine Vorverzerrungseinrichtung (11), die die Eingangsdaten in umgekehrter Richtung in ihrer Phase und ihrer Quadratur $a_n = (a'_n, a''_n)$ vor der Übergabe an den Verstärker vorverzerrt, um die erwarteten Pegel zu übertragen und wobei die Vorverzerrungseinrichtung gleichzeitig L empfangene Symbole $a_{n+(L-1)/2}$, ..., $a_n$, ..., $a_{n-(L-1)/2}$ berücksichtigt, die hierzu vorübergehend in eine Batterie Eingangs-Schieberegister (10) eingespeichert wurden;

   . eine Adapterschaltung (19), die ausgehend von einer Demodulation (16) des übertragenen Datenflusses, die Vorverzerrungsschaltung (11) ständig an den Eingangsdatenfluß anpaßt, und zwar anhand einer Vergleichsschaltung (20), die die Eingangsdaten in Phase und Quadratur $(a'_n, a''_n)$ mit den demodulierten Daten in Phase und Quadratur $(y'_n, y''_n)$ vergleicht und die mittels einer Schnittstellenschaltung (22) einen Adaptionsalgorithmus zur Anwendung bringt; **dadurch gekennzeichnet**, daß die Adapterschaltung (19) eine zwischen Vergleichsschaltung (20) und Vorverzerrungseinrichtung (11) eingefügte Batterie von Zählern/Summierern (21) besitzt, die den Schwerpunkt jedes Flecks der empfangenen Konstellation ermittelt, indem sie eine Anzahl mittlerer Fehler berechnet, durch die die Vorverzerrungseinrichtung (11) adaptiert wird, und wobei die adaptive Vorverzerrungsschaltung mit Speicherung darüberhinaus vor dem Modulator (14) einen ersten Sendefilter $F_e$ ($13_1$, $13_2$) enthält, der auf die Kanäle in Phase und Quadratur einwirkt, sowie nach dem Demodulator (16) einen zweiten Filter $F_r$ ($17_1$, $17_2$) enthält, der ebenfalls auf die Kanäle in Phase und Quadratur einwirkt, und zwar dergestalt, daß das Filterprodukt aus $F_e$ und $F_r$ einer Nyquist-Filterung entspricht.

2. Adaptive Vorverzerrungsschaltung mit Speicherung nach Anspruch 1, **dadurch gekennzeichnet**, daß zwischen der Batterie Eingangsregister (10) und der Vorverzerrungseinrichtung (11) eine Transformationseinrichtung (50) von C in C/4 eingefügt ist, die die Konstellation C in eine Viertelkonstellation C/4 transformiert, indem sie alle empfangenen und zur Konstellation C gehörenden Symbole $a_n$ in ihre zum Quadranten C/4 gehörenden Abbilder $\tilde{a}_n$ transformiert, und daß sie die vor und nach dem Symbol $a_n$ liegenden Symbole um $k\pi/2$ rotiert, wobei für k je nach ursprünglichem Quadranten ein Wert von 0, 1, 2 oder 3 genommen wird, und bei der nach der Vorverzerrungseinrichtung (11) eine umgekehrte Transformationseinrichtung (53) von C/4 in C liegt, die die Ordnung der Konstellation C wiederherstellt, und bei der eine weitere Transformationseinrichtung (56) von C in C/4 in die Adapterschleife zwischen Adapterschaltung (19) und Demodulator (16) eingefügt ist.

3. Schaltung nach Anspruch 2, **dadurch gekennzeichnet**, daß die Transformationseinrichtung (50) von C nach C/4 die Abbild-Daten $\tilde{a}_n$ und die gedrehten Daten $a^t_{n-i}$ (mit $i \neq 0$) liefert und dazu enthält:

   . eine Batterie Rotationselemente (51), die auf die vor und nach dem Datum $a_n$ liegenden Daten $a_{n-i}$ wirkt,

   . ein Transformationselement 52 von C in C/4, das auf die Daten $a_n$ wirkt.

4. Schaltung nach Anspruch 3, **dadurch gekennzeichnet**, daß ein Rotationselement der Batterie (51) enthält:

   - ein Exklusiv-Oder-Gatter (62), das die beiden Vorzeichenbits von $a'_n$ bzw. $a''_n$ erhält und ein Steuersignal $S_1$ abgibt;

   - einen Permutierer (61), der an einem Eingang $a'_{n-i}$ und am anderen Eingang $a''_{n-i}$ empfängt, wobei $-(L-1)/2 \leq i \leq (L-1)/2$, und diese Daten an seinem Ausgang vertauscht, wenn $S_1$ einen bestimmten logischen Zustand einnimmt, bzw. nicht vertauscht, wenn $S_1$ den umgekehrten Zustand einnimmt, und wobei sich in jedem Ausgang des Permutierers ein Vorzeichenumkehrer ($63_1$, $63_2$) befindet, der jeweils vom ursprünglichen Vorzeichenbit des entgegengesetzten Kanals angesteuert wird, um die gedrehten Daten $a'^t_{n-i}$ und $a''^t_{n-i}$ zu liefern.

5. Schaltung nach einem der Ansprüche 3 oder 4, **dadurch gekennzeichnet**, daß das Transformationselement (52) (56) von C in C/4 ein Exklusiv-Oder-Gatter (72) enthält, das die beiden Vorzeichenbits von $a'_n$ bzw. $a''_n$ empfängt und ein Steuersignal $S_2$ abgibt, das seinerseits

einen ersten Permutierer (71) ansteuert, der die beiden anderen Datenbits $a'_n$ und $a''_n$ miteinander vertauscht, wenn $S_2$ einen bestimmten logischen Zustand einnimmt, bzw. nicht vertauscht, wenn $S_2$ den umgekehrten Zustand einnimmt, um so die Abbild-Daten

$$\tilde{a}_n = (\tilde{a}'_n, \tilde{a}''_n)$$

zu bilden.

6. Schaltung nach einem der Ansprüche 2 bis 5, dadurch gekennzeichnet, daß das Transformationselement (53) von C/4 in C ein Exklusiv-Oder-Gatter (75) enthält, das die beiden Vorzeichenbits von $(a'_n, a''_n)$ erhält und ein Steuersignal $S_3$ abgibt, das seinerseits einen Permutierer (76) ansteuert, der:

   . an einem Eingang die Abbild-Daten $\tilde{b}'_n$ zusammen mit dem Vorzeichenbit von $a''_n$ empfängt,

   . am anderen Eingang die Abbild-Daten $\tilde{b}''_n$ zusammen mit dem Vorzeichenbit von $a'_n$ empfängt,

   und der an seinem Ausgang diese Eingangsdaten vertauscht, wenn $S_3$ einen bestimmten logischen Zustand einnimmt, bzw. nicht vertauscht, wenn $S_3$ den umgekehrten Zustand einnimmt, um so die vorverzerrten Daten $b_n = (b'_n, b''_n)$ zu bilden.

7. Schaltung nach einem der Ansprüche 1 bis 6, dadurch gekennzeichnet, daß die Anzahl der berücksichtigten Symbole $L = 3$ beträgt, so daß: $a_{n-1}$, $a_n$, $a_{n+1}$ berücksichtigt werden.

8. Schaltung nach einem der Ansprüche 3 bis 7, dadurch gekennzeichnet, daß die Transformationseinrichtung (50) von C in C/4 am Ausgang des Rotationselementes (51) einen Kodierer K'/K (57) enthält, der die K Bits jedes Symbols in K' Bits umkodiert (mit $K' < K$).

9. Schaltung nach Anspruch 8, dadurch gekennzeichnet, daß die K' ausgewählten Bits die jeweils K' höchstwertigen Bits sind.

10. Schaltung nach Anspruch 9, dadurch gekennzeichnet, daß $K' = 4$ ist, wobei die 2 Vorzeichenbits und die 2 höchstwertigen Datenbits berücksichtigt werden.

11. Schaltung nach Anspruch 9, dadurch gekennzeichnet, daß $K' = 2$ ist, wobei die 2 Vorzeichenbits berücksichtigt werden.

FIG.1

FIG. 2A

FIG. 2B

EP 0 387 948 B1

FIG. 3A

FIG. 3B

EP 0 387 948 B1

FIG. 4

EP 0 387 948 B1

FIG. 5

EP 0 387 948 B1

FIG. 6

FIG. 7A

FIG. 7B

FIG. 7C

FIG. 8

FIG. 9